# EUROPEAN PATENT APPLICATION

(11) **EP 2 242 109 A1**
(43) Date of publication of application: **20.10.2010**
(21) Application number: 09158001.9
(22) Date of filing: 16.04.2009
(51) Int. Cl.: H01L 31/0224, H01L 31/02

(54) **Thin-film solar cell module**

(71) Applicant: Applied Materials, Inc., Santa Clara, CA 95054 (US)
(72) Inventor: Straub, Axel, 55218, Ingelheim (DE); Repmann, Tobias, 63755, Alzenau (DE)
(74) Representative: Schickedanz, Willi

(57) **Abstract**

The invention relates to a thin-film solar cell module (71) in which a layer (72) of TCO is applied on a glass substrate (73). On this layer (72) of TCO is disposed a semiconductor layer (75) on which is applied an electrically conducting backside layer (85). The backside layer (85) includes a bridge element (88) in contact with the layer (72) of TCO. Directly on the layer (72) of TCO are applied busbars (82) by means of a printing method. The busbars (82) are herein connected with the backside layer (85) via the layer (72) of TCO.

## Description

The invention relates to a thin-film solar cell module according to the preamble of patent claim 1.

A solar cell is a large-area exemplary form of a photovoltaic element in which the incident radiative power of sunlight is directly converted into electric power. The conversion of the radiative power into electric power rests on the internal photoelectric effect of a semiconductor material. Silicon has been found to be especially suitable as starting material for solar cells. Apart from mono- and polycrystalline silicon, amorphous silicon has increasingly also been utilized for the production of solar cells. Tandem cells are also utilized as solar cells. More recently, so-called thin-film solar cells are also applied, which are approximately 100 times thinner than solar cells of silicon wafers, and which are comprised, for example, of gallium arsenide (GaAS), cadmium telluride (CdTe) or amorphous silicon.

A conventional solar cell is, for example, 100 mm wide, 100 mm long and 0.25 mm thick. On the front side of this square solar cell are located, for example, several contact fingers which are connected with their one end to a common contact finger busbar. This busbar is coupled with a contact connector which is also connected to an adjacent solar cell. The contact connector is enclosed with its solar cell-side end between a semiconductor and a cover glass with antireflective coating (*cf.* WO 2005/004242 A2).

The busbar is a thin filament resting on a metal layer or another electrically well conducting layer. Since the electric power of the solar cell is conducted toward the outside via the busbar, the quality of the electrical connection between busbar and metal layer is of great significance for the efficiency of the solar cell. This electrical connection is conventionally established by means of soldering, welding or adhesion. All three methods are labor intensive and can only be automated with difficulty.

In addition to the conventional solar cells, there are also so-called thin-film solar cells produced by coating a substrate. Herein, for example, a glass sheet is provided with layers of electrically conducting or semiconducting materials which are only a few □m thick. The discrete layers are here applied using various processes. After each coating step the particular layer is divided into basic structures of thin material strips in order to produce a series circuit of the layers of the complete solar cell module.

The separation of the conducting or semiconducting layers can be carried out by means of lasers or by means of mechanical or chemical means. A thin-film solar cell is substantially comprised of a layer of TCO (= Transparent Conductive Oxides), a semiconductor layer (for example amorphous silicon = a-Si) and a metal layer. The TCO utilized is preferably ITO, ZnO or SnO₂. However, amorphous silicon can also be utilized together with microcrystalline silicon (□Si) or cadmium telluride (CdTe) or copper indium diselenide (CIS).

The metal layer serving as the back electrode is, for example, comprised of molybdenum, aluminum.

A method for the production of series-connected thin-film solar cells is already known, in which onto a large area of a substrate successively a first electrode layer, at least a layer of a semiconductor material, and a second electrode layer are applied and wherein the layers are structured for their interconnection (DE 37 12 589 A1). Herein the first electrode layer is structured before the further layers are applied. The structuring here is comprised of the chemical conversion of parallel strips or of the ablation of such strips. Parallel to these strips are applied strips of conducting pastes (stitch bars), which have the function in a finished thin-film solar cell assembly have the function to establish the electrically conducting connection between the first electrode layer and a second electrode layer, such that the discrete thin-film solar cells are connected in series.

A method for the production of a thin-film solar cell structured thusly, which comprises one or several transparent layers, is disclosed, for example, in EP 0 536 431 A1. In this method a laser-induced material ablation is carried out. The material is directly irradiated with a suitable laser, wherein the ablation of the material takes place by vaporization. For the material ablation the irradiation takes place with a laser pulse through the transparent layer with a wavelength in the absorption range of the thin layer. The irradiated thin-film area, together with optionally superjacent layers, is ablated from the transparent layer leaving no residues.

In a further known method for the series interconnection of thin-film solar cells, strip-shaped cells are formed with operating voltages of, for example, 0.7 V, with which cells with operating voltages of, for example, 12 V/24 V, thus series interconnected, can be produced (EP 0 232 749 A2 = US 4 745 078 A). This method is intended to circumvent the difficulties that occur upon the separation of the amorphous silicon layer and the subsequent selective separation of the metal layer by means of a laser.

Further known is a series-interconnected thin-film solar cell module of crystalline silicon, whose front electrodes are generated by means of screen printing and in which the series interconnection is established via contact grooves (DE 37 27 825 A1).

Until now only metal filaments have been employed as busbars, which had been applied on the metal layers of the thin-film solar cell modules. However, applying these metal filaments on the thin-film solar cell modules is highly labor intensive and the application can only be automated with difficulty. These metal filaments can further be easily detached from the thin-film solar cell module since the connection between the metal layers and the metal filaments was only very weak. A further problem comprises that through the structure of the thin-film solar cell modules provided with metal filaments, bubbles are frequently formed if onto the thin-film solar cell module further layers are applied.

The present invention therefore addresses the problem of providing a thin-film solar cell module in which the conventional metal filaments are replaced by busbars whose thickness is very low and which are securely disposed on the thin-film solar cell module.

This problem is resolved according to the features of patent claim 1.

The invention consequently relates to a thin-film solar cell module in which a layer of TCO (Transparent Conductive Oxides) is applied on a glass substrate. On this layer of TCO is disposed a semiconductor layer on which is applied an electrically conducting backside layer. The backside layer comprises a bridge element in contact with the layer of TCO. Directly on the layer of TCO are applied busbars by means of a printing method. The busbars, however, can also be directly disposed on the glass substrate. The busbars are connected with the backside layer via the layer of TCO. It is also feasible to apply the busbars on the backside layer.

The advantage of this invention comprises that the busbars can be applied very simply on the thin-film solar cell module. The application of these busbars takes place by printing methods, for example using an inkjet printing method. These printing methods can be readily automated and are therefore cost-effective. The thus produced busbars have a very low thickness and are directly in contact on the metal layer of the thin-film solar cell modules. However, it is also feasible to dispose the busbars within the thin-film solar cell module. If the thin-film solar cell modules are provided with a protective layer, no bubble formation occurs any longer. These thin-film solar cell modules according to the invention, further, have a high long-term stability.

Embodiment examples of the invention are shown in the drawing and will be described in further detail in the following.

In the drawing depict:
Fig. 1 a plan view onto a thin-film solar cell module with two busbars,
Fig. 2 a cross section A-A through the central region of the thin-film solar cell module depicted in Figure 1,
Fig. 3 a cross section A-A through a margin region of the thin-film solar cell module depicted in Figure 1,
Fig. 4 a margin region of a variant of the thin-film solar cell module depicted in Figure 3,
Fig. 5 a margin region of a further variant of the thin-film solar cell module depicted in Figure 3.

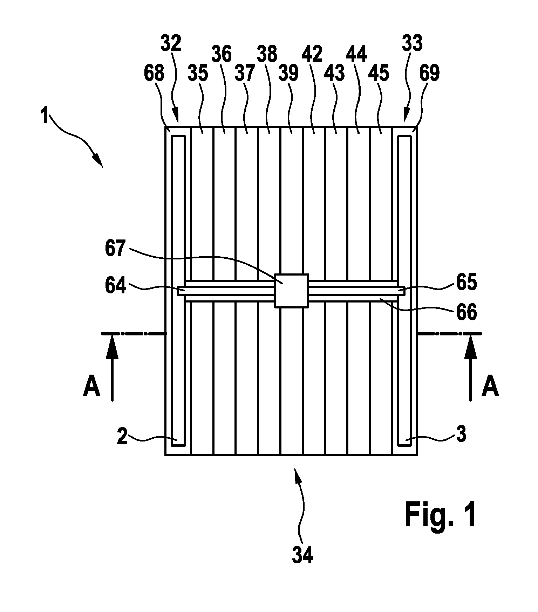

Figure 1 shows a plan view onto the backside of a thin-film solar cell module 1 which can have a size, for example, of 1.1 m x 1.3 m. This thin-film solar cell module 1 depicted in Figure 1 is shown schematically. The thin-film solar cell module 1 includes two margin regions 32, 33 as well as a center region 34 located between these two margin regions 32, 33. The thin-film solar cell module 1 includes several solar cells 35 to 39, 42 to 45, one disposed next to the other. In each of the two margin regions 32, 33 is provided a busbar 2, 3. These busbars 2, 3 are also disposed on solar cells 68, 69. The busbars 2, 3 extend substantially parallel to the solar cells 35 to 39, 42 to 45. The busbars 2, 3 according to the invention are not conventional metal filaments but rather layers preferably having a thickness of only a few micrometers. The busbars 2, 3 are only a few millimeters wide and extend nearly over the entire length of the thin-film solar cell module 1. The width as well as the length of these busbars 2, 3, however, depends on the material of the solar cell as well as on the current generated by the solar cell module 1. However, the width of these busbars 2, 3 lies typically between 3 to 7 mm. In Figure 1 are further evident two ribbon cables 64 and 65, which are at least partially disposed on an insulating tape 66. Both ribbon cables 64, 65 extend from a collection junction box 67 in the direction toward the busbars 2, 3. As shown in Figure 1, the ribbon cable 64 is in contact with the busbar 2 and the ribbon cable 65 with the busbar 3. The ribbon cables 64 and 65 are also only a few millimeters wide.

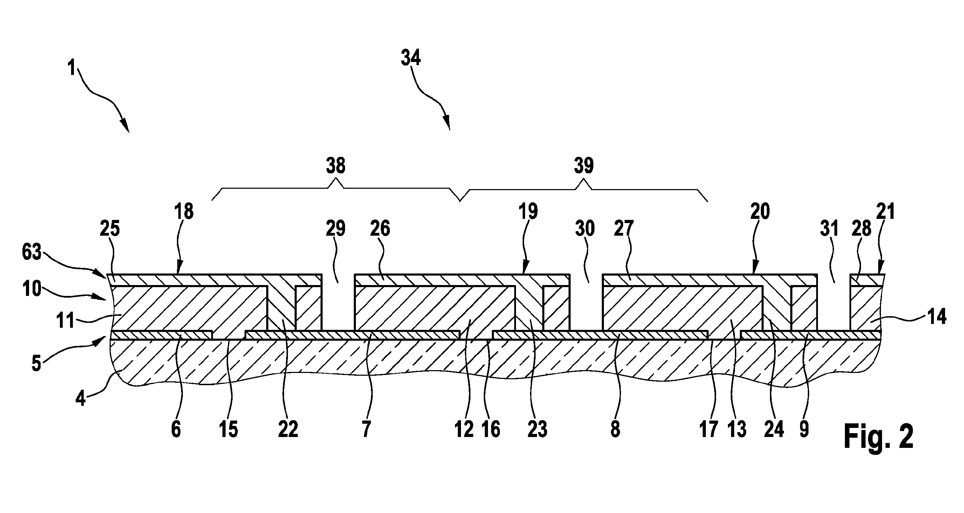

Figure 2 depicts a cross section A-A through a cutaway of the central region 34 of the thin-film solar cell module 1. The center region 34 of the solar cell module 1 includes several solar cells 38, 39 one disposed next to the other. The solar cell module 1 comprises a glass substrate 4, for example a glass sheet, on which a layer 5 of TCO (Transparent Conductive Oxides) is disposed. The TCO can be, for example, a 1 □m thick layer of ZnO or fluorine-doped ZnO. This layer 5 is divided into several segments 6 to 9, these segments 6 to 9 being disposed at a certain distance from one another. Between the individual segments 6 to 9, gaps 15 to 17 are hereby formed. On layer 5 of TCO is applied a layer 10 comprised of a semiconducting material. This semiconductor layer 10, in turn, is divided into several sections 11 to 14. The material of the semiconductor layer 10 can be, for example, amorphous silicon or crystalline silicon. It is understood that the layer 10 can also be microcrystalline silicon. The amorphous silicon has herein preferably a p-i-n structure. Also, instead of amorphous silicon, another material can also be utilized which has the desired semiconductor properties. Between these sections 11 to 14 occur gaps 29 to 31. The amorphous silicon of layer 10 is disposed in the regions of the layer 5, in which the gaps 15 to 17 occur, directly onto the glass substrate 4. On the layer 10 is disposed a backside layer 63 divided into several regions 18 to 21. This backside layer is comprised of an electrically conducting material, preferably a metal or a metal alloy. On each section 11 to 14 of the semiconductor layer 10 is disposed a region 18 to 21 of the backside layer 63. These regions 18 to 21 are comprised of a plate-like segment 25 to 28 as well as a downwardly directed bridge element 22 to 24. The bridge elements 22 to 24 connect the plate-like segments 25 to 28 of the backside layer 63 with one segment 6 to 9 each of layer 5 comprised of TCO. The plate-like segments 25 to 28 of regions 18 to 21 overlap at least partially two segments 6 to 9 of layer 5. By this arrangement a serial connection is obtained.

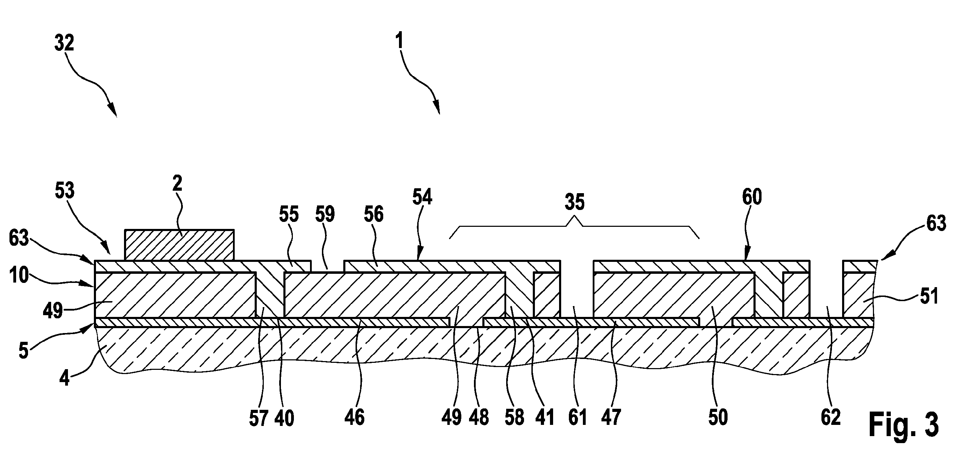

Figure 3 shows a cross section A-A through the margin region 32 of the thin-film solar cell module 1 depicted in Figure 1. The layer 5 disposed on the glass substrate 4 is divided into at least two segments 46 and 47, between which a gap 48 is located. On layer 5 of TCO is applied the semiconductor layer 10, preferably comprised of amorphous silicon. The semiconductor layer 10 is also divided into several sections of which in Figure 3 sections 49 to 51 are evident. Therefore on section 49 of the semiconductor layer 10 also two regions 53 and 54 of the backside layer 63 are disposed, whereas on section 50 only a region 60 is disposed. Each region 53, 54 has a plate-like segment 55, 56 as well as a bridge element 57, 58. These bridge elements 57, 58 connect the plate-like segments 55, 56 of regions 53, 54 with the layer 5 of TCO. The two plate-like segments 55, 56 are not connected with one another but rather are spaced apart in such form that between them a gap 59 occurs. On the region 53 of the backside layer 63 is disposed the busbar 2. The bridge elements 57, 58 thus form the electrical connection between the plate-like segments 55, 56 and the layer 5, of TCO.

The two ribbon cables as well as the insulating tape are not shown in Figure 3 for the sake of clarity. When applying the ribbon cables it is especially of significance that these are connected either with the busbars or with the backside layer 63. It is understood that the ribbon cables, in addition, can be connected with the backside layer 63 as well as also with the busbars 2, 3. Although no longer shown in Figure 3, it is obvious to a person of skill in the art that the solar irradiation takes place via the glass substrate 4 in the direction toward the backside layer 63.

The production of the solar cell module 1 depicted in Figures 1 to 3 is carried out in the following manner.

A glass substrate 4 is prepared and thereon a layer 5 of TCO is applied which covers the glass substrate 4 completely. The layer 5 is subsequently treated in very specific regions with a laser. This laser has a wavelength corresponding to the absorption range of layer 5. By treating the layer 5 with a laser a strip-form portion of the layer 5 is ablated whereby gaps are formed such as for example gap 48 evident in Figure 3. Such a working method of thin-film structures with a laser is disclosed, for example, in EP 0 536 431 A1, which is the reason for not describing the method in detail here. After layer 5 has been treated with a laser, the semiconductor layer 10 is applied onto layer 5. The material of the semiconductor layer 10 is preferably amorphous silicon with a p-i-n structure or crystalline silicon. Layer 10 is subsequently treated at specific sites with a laser of suitable wavelength whereby strip-shaped gaps 40, 41 (*cf.* Figure 3) are formed in which subsequently the bridge elements 57, 58 of regions 53, 54 are disposed. After the laser treatment of layer 10, a backside layer 63 is applied onto layer 10. Application of the backside layer 63 onto layer 10 takes place, for example, by sputtering. Herein gaps 40, 41 are also filled with sputter material. The backside layer 63 can, for example, be comprised of ZnO doped with Al. The backside layer 63 can also comprise ZnO and Ag and NiV or ZnO and Al and NiV. After layer 10 has been provided with the backside layer 63, busbars 2 and 3 are applied in the margin regions 32 and 33 of the backside layer 63 (*cf.* Figures 1 and 3).

Busbars 2, 3 can be applied using a screen printing method or a thermal transfer printing method. However, the busbars 2, 3 can also be disposed by means of an inkjet printing method on the backside layer 63. The principle of the inkjet printing method is described, for example at the website http://www.conductiveinkjet.com. In this method a catalytic layer is applied in the form of a strip onto the margin regions 32, 33. These strips have already the desired composition of the busbars. After the strips have been applied, they are cured by means of UV. The glass substrate 4 coated with several layers is subsequently introduced into an electrolytic solution. In this solution a film grows autocatalytically in the region of the strips. The process is terminated when the strips have the desired size.

A further laser treatment subsequently takes place, whereby the gaps 59, 61 and 62 are formed.

On the backside layer 63 an insulating tape is subsequently disposed on which two ribbon cables are disposed (*cf.* in this connection Figure 1). The backside layer 63 of the solar cell module 1 is subsequently provided with a protective layer. This protective layer can be, for example, a glass layer covered with synthetic material. Synthetic materials to be considered are in particular ethylene vinyl acetate or polyvinyl butylaldehyde. However, it is also feasible to apply a protective layer comprised of ethylene vinyl acetate and Tedlar® on the backside layer 63 of the solar cell module 1. On the backside layer 63 of the solar cell module 1, lastly, the collection junction box is disposed. The protective layer as well as the collection junction box, however, are not shown in Figure 3. Since the busbars 2, 3 preferably have a thickness of a few micrometers and are directly in contact on the backside layer 63, formation of bubbles is prevented.

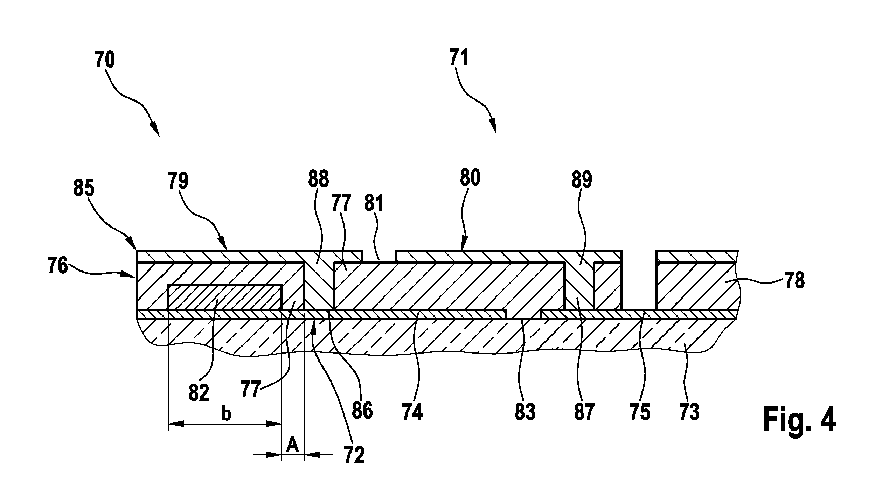

Figure 4 depicts a margin region 70 of a variant of a thin-film solar cell module 71 of the thin-film solar cell module 1 shown in Figure 3. This solar cell module 71 also comprises a layer 72 of TCO, which is disposed on a glass substrate 73. On this layer 72 is located a busbar 82. Layer 72 is also divided into several segments 74 and 75. On layer 72 are located a semiconductor layer 76, which is preferably comprised of amorphous silicon. Layer 76 is, again, divided into several sections of which in Figure 4 sections 77 and 78 are evident. Section 77 includes two gaps 86 and 87. On section 77 are disposed two regions 79, 80 of a backside layer 85. Evident are also the bridge elements 88 and 89 of backside layer 85 disposed in the gaps 86 or 87. The bridge elements 88 and 89 connect the layer 72 of TCO with regions 79 and 80 of the backside layer 85. The backside layer 85 is preferably comprised of ZnO and can be doped with Al. The backside layer 85 can also comprise ZnO and Ag and NiV. Also, the backside layer 85 can comprise ZnO and Al and NiV. The two regions 79, 80 are not in contact with one another such that between these regions 79, 80 a gap 81 is located. The thin-film solar cell module 71 also includes two busbars, of which in Figure 4 only the busbar 82 is evident. This busbar 82 also has a thickness of only a few micrometers. The other busbar opposite busbar 82 is not evident in Figure 4. Busbar 82, which has a width b, is seated on layer 72 of TCO. Therewith the sole difference between the solar cell module 1 and the solar cell module 71 lies in the disposition of the busbars in the margin regions. As can be seen in Figure 4, the busbar 82 is disposed at a certain distance A from the bridge element 88. Distance A is here preferably less than width b of the busbar 82, which means A < b. It is obvious to a person of skill in the art that the busbar 82 can also be disposed directly at the bridge element 88. In this case distance A is equal to zero. The same applies also to busbars opposing busbar 82, which is not shown in Figure 4.

The production of the thin-film solar cell module 71, again, takes place by preparation of the glass substrate 73 and subsequent coating of the glass substrate 73 with TCO, whereby the layer 72 is formed. At the two opposite margin regions the busbars are subsequently applied using a printing method, for example, a screen printing method, a thermal transfer printing method or an inkjet printing method.

Layer 72 is subsequently treated with a laser of suitable wavelength such that a structured layer 72 is formed which includes several gaps, of which in Figure 4 only gap 83 is evident. After layer 72 has been treated by means of laser, the layer 76 of amorphous or crystalline silicon is applied. This silicon also has a p-i-n structure. As in the production of the thin-film solar cell module 1, the layer 76 of the thin-film solar cell module 71 is also treated with a laser of suitable wavelength such that gaps are formed into which subsequently material of the backside layer 85 can be introduced.

After the layer 76 has been treated with a laser, the backside layer 85 is applied. A further treatment of the layer system with a laser of suitable wavelength is subsequently carried out such that the thin-film solar cell module 71 with the structure depicted in Figure 4 is formed. Lastly, onto the backside layer 85 of the thin-film solar cell module 71 a protective layer is applied, which, however, is not shown in Figure 4. Since the busbars are located in the interior of the thin-film solar cell module 71, formation of bubbles can be obviated.

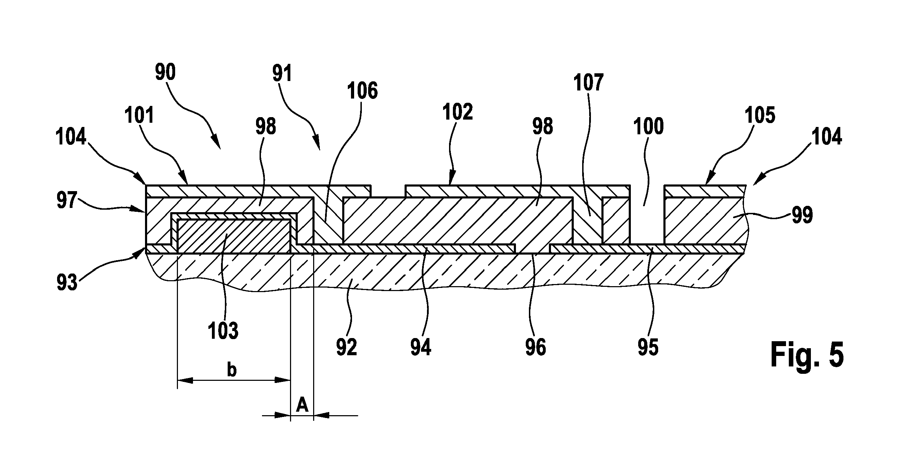

Figure 5 shows a margin region 90 of a further variant of a thin-film solar cell module 91 of the thin-film solar cell module 1 depicted in Figure 3. On a glass substrate 92 is disposed a layer 93 of TCO. This layer 93 is divided into several segments, wherein in Figure 5 segments 94 and 95 are evident. Between these two segments 94 and 95 of layer 93 is located a gap 96. On layer 93 is applied a semiconductor layer 97, which is preferably comprised of amorphous silicon. The semiconductor layer 97 is also divided into several sections. In Figure 5 the sections 98 and 99 are evident. They are separated from one another by a gap 100. On the layer 97 is disposed a backside layer 104, which is also divided into several regions. In Figure 5 only three regions 101, 102, 105 of the backside layer 104 are evident. Regions 101 and 102 of backside layer 104 form each a bridge element 106 and 107. On section 98 of the semiconductor layer 97 two regions 101 and 102 of the backside layer 104 are disposed. The thin-film solar cell module 91 also includes two busbars, of which only the busbar 103 disposed in the margin region 90 is evident. This time, however, busbar 103 is not disposed on layer 94 of TCO, but rather directly on the glass substrate 92, whereby the busbar 103 is at least partially encased by layer 93. Busbar 103, again, has a width b. This busbar 103 is disposed at a distance A from the bridge element 106. Since the resistance is to be kept as low as possible, it is advantageous if the distance A is kept as small as possible. Distance A is here preferably less than the width b of the busbar 103. It is understood that, if the distance A is zero, that means A = 0, the busbar 103 is disposed directly at the bridge element 106. In this case it is not necessary that between busbar 103 and bridge element 106 the layer 93 of TCO is disposed. The busbar, not shown in Figure 5, opposite of busbar 103 can also be disposed directly at the adjacent bridge element or beneath the adjacent bridge element.

The difference between the solar cell module 91 and the two solar cell modules 1 and 71 thus lies therein that in the solar cell module 91 the two busbars are disposed directly on the glass substrate 92. The application of the two busbars on the glass substrate 92 can therein, again, take place for example by means of a screen printing method, a thermal transfer printing method or an inkjet printing method, wherein the application of the busbar 103 represents the first production step in the case of the exemplary form according to Figure 5.

Although in the embodiment examples the layers are each ablated using a laser, it is obvious to a person of skill in the art that the layers can also be ablated using other methods, for example by etching of the layers.

The ribbon cables are either to be connected with the busbars or with the backside layer. It is obvious to a person of skill in the art that the ribbon cables can be connected with the backside layer as well also with the busbars. In the embodiment examples according to Figures 4 and 5 the ribbon cables are connected with the backside layer. In the embodiment example according to Figures 1 to 3 the ribbon cables, in contrast, are in contact with the busbars.

The advantage of these thin-film solar cell modules according to the invention is consequently their simple and cost-effective production, since in simple manner an electrical connection between the busbars and the electrically conducting backside layer can be established.

In the thin-film solar cell modules according to the embodiment examples there is always the assurance that between the busbars and the backside layer an electrical connection is established. Thus, as is evident in Figure 3, the busbar is disposed directly on the backside layer. It is therewith obvious to a person of skill in the art that the busbar can be disposed in the semiconductor layer, however directly beneath the backside layer. It is, however, also feasible to dispose the busbars either directly on the TCO layer (Figure 4) or on the glass substrate (Figure 5). In the two embodiment examples according to Figures 4 and 5 the contact between the busbars and the backside layer is established through the TCO layer. It is herein advantageous if the distance between the busbars and the bridge elements of the backside layers is kept as short as possible. The busbars can also be disposed directly at the adjacent bridge element.

Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

### Reference numerals

- 1: solar cell module
- 2: bus bar
- 3: bus bar
- 4: glass substrate
- 5: layer
- 6: segment
- 7: segment
- 8: segment
- 9: segment
- 10: layer
- 11: section
- 12: section
- 13: section
- 14: section
- 15: gap
- 16: gap
- 17: gap
- 18: region
- 19: region
- 20: region
- 21: region
- 22: bridge element
- 23: bridge element
- 24: bridge element
- 25: plate-like segment
- 26: plate-like segment
- 27: plate-like segment
- 28: plate-like segment
- 29: gap
- 30: gap
- 31: gap
- 32: margin region
- 33: margin region
- 34: central region
- 35: solar cell
- 36: solar cell
- 37: solar cell
- 38: solar cell
- 39: solar cell
- 40: gap
- 41: gap
- 42: solar cell
- 43: solar cell
- 44: solar cell
- 45: solar cell
- 46: segment
- 47: segment
- 48: gap
- 49: section
- 50: section
- 51: section
- 53: region
- 54: region
- 55: plate-like segment
- 56: plate-like segment
- 57: bridge element
- 58: bridge element
- 59: gap
- 60: region
- 61: gap
- 62: gap
- 63: backside layer
- 64: ribbon cable
- 65: ribbon cable
- 66: insulating tape
- 67: collection junction box
- 68: solar cell
- 69: solar cell
- 70: margin region
- 71: solar cell module
- 72: layer
- 73: glass substrate
- 74: segment
- 75: segment
- 76: semiconductor layer
- 77: section
- 78: section
- 79: region
- 80: region
- 81: gap
- 82: busbar
- 83: gap
- 85: backside layer
- 86: gap
- 87: gap
- 88: bridge element
- 89: bridge element
- 90: margin region
- 91: solar cell module
- 92: glass substrate
- 93: layer
- 94: segment
- 95: segment
- 96: gap
- 97: semiconductor layer
- 98: section
- 99: section
- 100: gap
- 101: region
- 102: region
- 103: busbar
- 104: backside layer
- 105: region
- 106: bridge element
- 107: bridge element

## Claims

1. Thin-film solar cell module (1, 71, 91) comprising
a) a layer (5, 72, 93) of TCO applied on a glass substrate (4, 73, 92),
b) a semiconductor layer (10, 76, 97) disposed on said layer (5, 72, 93) comprised of TCO, and
c) an electrically conducting backside layer (63, 85, 104) applied on the semiconductor layer (10, 76, 97), wherein the backside layer (63, 85, 104) is connected with the layer (5, 72, 93) of TCO via bridge elements (22 - 24, 88; 89, 106; 107),
**characterized in that** at least two busbars (2, 3; 82; 103) located opposite one another are provided, which are connected with the backside layer (63, 85, 104) and are applied by using printing methods.

2. Thin-film solar cell module (1, 71, 91) as claimed in claim 1, **characterized in that** the busbars (2, 3) are disposed on the backside layer (63).

3. Thin-film solar cell module (71) as claimed in claim 1, **characterized in that** the busbars (82) are disposed on the layer (72) of TCO.

4. Thin-film solar cell module (71) as claimed in claim 3, **characterized in that** the busbars (82) are disposed adjacent to a bridge element (88), wherein the layer (72) of TCO connects the bridge element (88) with the busbar (82), and the distance (A) between the busbar (82) and the bridge element (88) is less than the width (b) of the busbar (82).

5. Thin-film solar cell module (71) as claimed in claim 3, **characterized in that** the busbars (82) are in contact with a bridge element (88).

6. Thin-film solar cell module (91) as claimed in claim 1, **characterized in that** the busbars (103) are disposed on the glass substrate (92).

7. Thin-film solar cell module (91) as claimed in claim 6, **characterized in that** the busbars (103) are at least partially encased by the layer (93) of TCO.

8. Thin-film solar cell module (91) as claimed in claim 7, **characterized in that** the busbars (103) are disposed adjacent to a bridge element (106), wherein the layer (93) of TCO connects the bridge element (106) with the busbar (103), and the distance (A) between the busbar (103) and the bridge element (106) is less than the width (b) of the busbar (103).

9. Thin-film solar cell module (71) as claimed in claim 6, **characterized in that** the busbars (103) are in contact with a bridge element (106).

10. Thin-film solar cell module (1, 71, 91) as claimed in claim 1, **characterized in that** the busbars (2, 3; 85; 103) are disposed at oppositely located margin regions (32, 33) of the thin-film solar cell module (1, 71, 91).

11. Thin-film solar cell module (1, 71, 91) as claimed in claim 1, **characterized in that** the backside layer (63, 85, 104) comprises a three layer system comprising the layers of ZnO and Al and NiV.

12. Thin-film solar cell module (1) as claimed in claim 1, **characterized in that** the two ribbon cables (64, 65) are disposed on an insulating tape (66) disposed between the ribbon cables (64, 65) and the backside layer (63).

13. Thin-film solar cell module (1) as claimed in claim 1, **characterized in that** one ribbon cable (64, 65) each is in contact with one of the busbars (2, 3).

14. Thin-film solar cell module (1, 71, 91) as claimed in claim 1, **characterized in that** the printing method is an inkjet printing method.

15. Thin-film solar cell module (1, 71, 91) as claimed in claim 1, **characterized in that** the printing method is a screen printing method.

16. Thin-film solar cell module (1, 71, 91) as claimed in claim 1, **characterized in that** the printing method is a thermal transfer printing method.

17. Thin-film solar cell module (1, 71, 91) as claimed in claim 1, **characterized in that** the backside layer (63, 85, 104) comprises a three layer system comprising the layers of Zn0 and Ag and NiV.
